# EUROPEAN PATENT APPLICATION

(11) **EP 4 386 845 A1**
(43) Date of publication of application: **19.06.2024**
(21) Application number: 22948874.7
(22) Date of filing: 29.08.2022
(51) Int. Cl.: H01L 27/12, G09G 3/3233

(54) **ARRAY SUBSTRATE, DISPLAY PANEL AND DISPLAY DEVICE**

(30) Priority: 28.06.2022 CN 202210751702
(71) Applicant: Yungu (Gu'an) Technology Co., Ltd., Langfang, Hebei 065500 (CN)
(72) Inventor: GUO, Enqing, Langfang, Hebei 065500 (CN); LI, Junfeng, Langfang, Hebei 065500 (CN); GAI, Cuili, Langfang, Hebei 065500 (CN); XING, Rubo, Langfang, Hebei 065500 (CN)
(74) Representative: Kraus & Lederer PartGmbB
(86) International application number: PCT/CN2022/115449
(87) International publication number: WO 2024/000783

(57) **Abstract**

Provided are an array substrate, a display panel and a display device. The array substrate includes a substrate, an active layer, and multiple metal layers. Multiple pixel circuits are formed in the array substrate. A pixel circuit of the multiple pixel circuits includes a drive transistor, a first initialization transistor, and a second initialization transistor. The multiple metal layers include at least a first metal wire extending in a first direction and a second metal wire extending in a second direction. The first metal wire and the second metal wire are located in different layers. The first initialization transistor is connected between the first metal wire and a gate of the drive transistor and is configured to transmit a first initialization voltage on the first metal wire to the gate of the drive transistor. The second initialization transistor is connected between the second metal wire and a light-emitting element and is configured to transmit a second initialization voltage on the second metal wire to the light-emitting element. The technical solutions provided by the present application can improve the stability of the drive current so as to improve the uniformity of display brightness and display color cast.

## Description

The present application claims priority to Chinese Patent Application No. 202210751702.8 filed with the China National Intellectual Property Administration (CNIPA) on Jun. 28, 2022, the disclosure of which is incorporated herein by reference in its entirety.

### TECHNICAL FIELD

The present application relates to a field of display technology, for example, an array substrate, a display panel, and a display device.

### BACKGROUND

With the development of display technology, people have higher performance requirements for display devices.

Currently, pixel circuits in display panels have a common problem of leakage, which causes a change in display brightness, making it easy for human eyes to recognize abnormalities in the display picture and affecting the display effect of the display devices.

### SUMMARY

The present application provides an array substrate, a display panel and a display device to improve the display effect of a display picture.

According to an aspect of the present application, an array substrate is provided. The array substrate includes a substrate, an active layer, multiple metal layers and multiple pixel circuits.

The active layer and the multiple metal layers are stacked on one side of the substrate. The multiple pixel circuits are formed on the array substrate and a pixel circuit of the multiple pixel circuits includes a drive transistor, a first initialization transistor, and a second initialization transistor.

The multiple metal layers at least include a first metal wire extending in a first direction and a second metal wire extending in a second direction. The first metal wire and the second metal wire are located in different layers. The first initialization transistor is connected between the first metal wire and a gate of the drive transistor and is configured to transmit a first initialization voltage on the first metal wire to the gate of the drive transistor. The second initialization transistor is connected between the second metal wire and a light-emitting element and is configured to transmit a second initialization voltage on the second metal wire to the light-emitting element. The first direction and the second direction intersect and are perpendicular to the direction of the thickness of the array substrate, respectively.

According to another aspect of the present application, a display panel is provided and includes the array substrate provided by any embodiment of the present application.

According to another aspect of the present application, a display device is provided and includes the display panel provided by any embodiment of the present application.

In the technical solution provided by embodiments of the present application, an active layer and multiple metal layers are stacked on a substrate. The multiple metal layers at least include a first metal wire extending in a first direction and a second metal wire extending in a second direction. The first metal wire and the second metal wire are located in different layers. A first initialization transistor is connected between the first metal wire and a gate of a drive transistor and is configured to transmit a first initialization voltage on the first metal wire to the gate of the drive transistor. A second initialization transistor is connected between the second metal wire and a light-emitting element and is configured to transmit a second initialization voltage on the second metal wire to the light-emitting element. In the technical solution provided by embodiments of the present application, the first metal wire and the second metal wire are configured in different layers so that corresponding initialization voltages can be provided to the first initialization transistor and the second initialization transistor to adjust the potential state of the gate of the drive transistor and of the anode of the light-emitting element. In this manner, the stability of the drive current is enhanced, and the uniformity of display brightness and display color cast are improved. Additionally, the first metal wire and the second metal wire are configured in different layers in a limited layout space so that the layout space utilization can be enhanced, the layout structure can be optimized, and the display PPI can be improved.

### BRIEF DESCRIPTION OF DRAWINGS

FIG. 1 is a top view illustrating the structure of an array substrate according to an embodiment of the present application.
FIG. 2 is a schematic diagram illustrating the sectional structure of an array substrate according to an embodiment of the present application.
FIG. 3 is a schematic diagram illustrating the structure of a pixel circuit according to an embodiment of the present application.
FIG. 4 is a top view illustrating the structure of another array substrate according to an embodiment of the present application.
FIG. 5 is a schematic diagram illustrating the structure of another pixel circuit according to an embodiment of the present application.
FIG. 6 is a top view illustrating the structure of another array substrate according to an embodiment of the present application.
FIG. 7 is a top view illustrating the structure of another array substrate according to an embodiment of the present application.
FIG. 8 is a top view illustrating the structure of another array substrate according to an embodiment of the present application.
FIG. 9 is a top view illustrating the structure of another array substrate according to an embodiment of the present application.
FIG. 10 is a drive timing waveform diagram of a pixel circuit according to an embodiment of the present application.
FIG. 11 is another drive timing waveform diagram of a pixel circuit according to an embodiment of the present application.
FIG. 12 is a schematic diagram illustrating the structure of another pixel circuit according to an embodiment of the present application.
FIG. 13 is a drive timing waveform diagram of another pixel circuit according to an embodiment of the present application.
FIG. 14 is a drive timing waveform diagram of another pixel circuit according to an embodiment of the present application.
FIG. 15 is a top view illustrating the structure of another array substrate according to an embodiment of the present application.
FIG. 16 is a top view illustrating the structure of another array substrate according to an embodiment of the present application.
FIG. 17 is a schematic diagram illustrating the structure of another pixel circuit according to an embodiment of the present application.
FIG. 18 is a schematic diagram illustrating the structure of another array substrate according to an embodiment of the present application.
FIG. 19 is a schematic diagram illustrating the structure of another array substrate according to an embodiment of the present application.
FIG. 20 is a schematic diagram illustrating the structure of another array substrate according to an embodiment of the present application.
FIG. 21 is a schematic diagram illustrating the structure of another array substrate according to an embodiment of the present application.
FIG. 22 is a schematic diagram illustrating the structure of another array substrate according to an embodiment of the present application.
FIG. 23 is a schematic diagram illustrating the structure of another pixel circuit according to an embodiment of the present application.
FIG. 24 is a top view illustrating the structure of another array substrate according to an embodiment of the present application.
FIG. 25 is a schematic diagram illustrating the structure of another pixel circuit according to an embodiment of the present application.
FIG. 26 is a top view illustrating the structure of another array substrate according to an embodiment of the present application.
FIG. 27 is a schematic diagram illustrating the structure of another pixel circuit according to an embodiment of the present application.
FIG. 28 is a top view illustrating the structure of another array substrate according to an embodiment of the present application.
FIG. 29 is a view illustrating the structure of a display device according to an embodiment of the present application.

### DETAILED DESCRIPTION

The terms such as "first" and "second" in the description, claims, and preceding drawings of the present application are used to distinguish between similar objects and are not necessarily used for describing a particular order or sequence. It should be understood that the data used in this manner is interchangeable where appropriate so that the embodiments of the present application described herein may also be implemented in a sequence not illustrated or described herein. Additionally, terms "comprising", "including", and any other variations thereof are intended to encompass a non-exclusive inclusion. For example, a process, method, system, product, or device that includes a series of steps or units not only includes the expressly listed steps or units but may also include other steps or units that are not expressly listed or are inherent to such a process, method, product, or device.

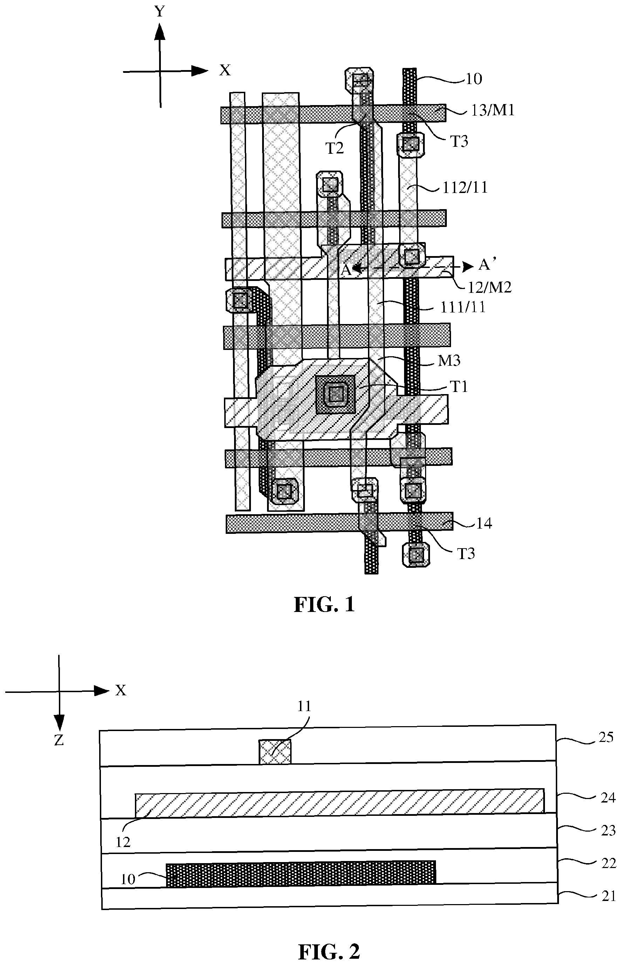

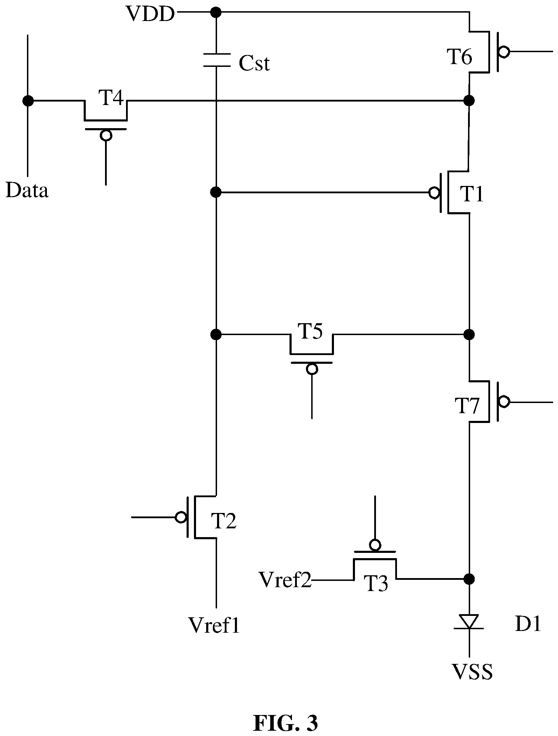

FIG. 1 is a top view illustrating the structure of an array substrate according to an embodiment of the present application. FIG. 2 is a schematic diagram illustrating the sectional structure of an array substrate according to an embodiment of the present application. For example, FIG. 2 may illustrate a sectional structure obtained by cutting the array substrate in FIG. 1 along the section line AA'. FIG. 3 is a schematic diagram illustrating the structure of a pixel circuit according to an embodiment of the present application. With reference to FIGS. 1 to 3, an array substrate provided by this embodiment of the present application includes a substrate 21, an active layer 10, and multiple metal layers; the active layer 10 and the multiple metal layers are stacked on one side of the substrate 21, and multiple pixel circuits are formed on the array substrate and a pixel circuit of multiple pixel circuits includes a drive transistor T1, a first initialization transistor T2, and a second initialization transistor T3.

The multiple metal layers at least include a first metal wire 11 extending in a first direction and a second metal wire 12 extending in a second direction. The first metal wire 11 and the second metal wire 12 are located in different layers. The first initialization transistor T2 is connected between the first metal wire 11 and a gate of the drive transistor T1 and is configured to transmit a first initialization voltage Vrefl on the first metal wire 11 to the gate of the drive transistor T1.

The second initialization transistor T3 is connected between the second metal wire 12 and a light-emitting element D1 and is configured to transmit a second initialization voltage Vref2 on the second metal wire 12 to the light-emitting element D1. The first direction and the second direction intersect and are perpendicular to the direction of the thickness of the array substrate, respectively.

The first initialization transistor T2 is connected between the first metal wire 11 and the gate of the drive transistor T1, which can be understood that one electrode of the source or drain of the first initialization transistor T2 is electrically connected to the first metal wire 11 and that the other electrode of the source or drain of the first initialization transistor T2 is electrically connected to the gate of the drive transistor T1. The second initialization transistor T3 is connected between the second metal wire 12 and the light-emitting element D1, which can be understood that one electrode of the source or drain of the second initialization transistor T3 is electrically connected to the second metal wire 12 and that the other electrode of the source or the drain of the second initialization transistor T3 is electrically connected to the light-emitting element D1. The electrical connection may be a direct connection or an indirect connection. For example, the substrate 21 may be used for providing protection and support for the array substrate. The substrate 21 may be a flexible substrate made of a material such as polyimide (PI), Polyethylene Naphthalate Two Formic Acid Glycol Ester (PEN), or Polyethylene terephthalate (PET) or may be a hard substrate made of a material such as glass. The active layer 10 and multiple metal layers are sequentially disposed on one side of the substrate 21. The multiple metal layers are isolated from each other by an insulation layer. For example, the multiple metal layers include a first metal layer M1, a second metal layer M2, and a third metal layer M3. A first interlayer insulation layer 22 is disposed between the active layer 10 and the first metal layer M1. A second interlayer insulation layer 23 is disposed between the first metal layer M1 and the second metal layer M2. A third interlayer insulation layer 24 is disposed between the second metal layer M2 and the third metal layer M3. A fourth interlayer insulation layer 25 is also disposed on a side of the third metal layer M3 away from the substrate 21. The active layer 10 may be made of polysilicon, metal oxide, and other materials.

Multiple pixel circuits are formed on the array substrate for generating a drive current to drive the light-emitting element D1 connected to a pixel circuit to emit light. A pixel circuit is composed of at least a thin-film transistor. The thin-film transistor at least includes a drive transistor T1, a first initialization transistor T2, and a second initialization transistor T3. The first initialization transistor T2 is configured to initialize the gate potential of the drive transistor T1. The second initialization transistor T3 is configured to initialize the anode potential of the light-emitting element D1. Here, the data voltage on a data line Data is written into the gate of the drive transistor T1 through a data writing transistor T4, the drive transistor T1, and a threshold compensation transistor T5 and is stored on a storage voltage Cst, thereby achieving functions of data writing and threshold compensation. When a first light-emitting control transistor T6 and a second light-emitting control transistor T7 are turned on, the drive transistor T1 generates a drive current to drive the light-emitting element D1 to emit light.

In this embodiment, the first initialization voltage Vrefl is provided by the first metal wire 11, and the second initialization voltage Vref2 is provided by the second metal wire 12. The first metal wire 11 extends in the first direction. The second metal wire 12 extends in the second direction. Here, the first direction may be the Y direction, the second direction may be the X direction, and both the X direction and the Y direction are perpendicular to the direction of the thickness of the array substrate (that is, the Z direction). In conjunction with FIGS. 1 and 2, the first metal wire 11 and the second metal wire 12 are separately formed by mental materials in different layers of the multiple metal layers. For example, the first metal wire 11 is located at the third metal layer M3, and the second metal wire 12 is located at the second metal layer M2. The first metal wire 11 transmits the first initialization voltage Vrefl to the first initialization transistor T2. The second metal wire 12 transmits the second initialization voltage Vref2 to the second initialization transistor T3. Thus, the first metal wire 11 and the second metal wire 12 are configured in different layers so that the corresponding initialization voltages can be supplied to the gate of the drive transistor T1 and the anode of the light-emitting element D1 to enhance the threshold compensation effect on the drive transistor T1, increase the uniformity of the drive current, and reduce the effect of the parasitic capacitance of the light-emitting element D1 on the drive current to reduce color cast. Meanwhile, it is also possible to optimize the layout structure, which helps improve the space utilization rate of the layout and the display pixels per inch (PPI).

Of course, the initialization voltage supplied by the first metal wire 11 to the gate of the drive transistor T1 may be same as the initialization voltage supplied by the second metal wire 12 to the anode of the light-emitting element D1. The pixel circuit is controlled by the drive timing to enhance the threshold compensation effect on the drive transistor T1, increase the uniformity of the drive current, and reduce the effect of the parasitic capacitance of the light-emitting element D1 on the drive current to reduce color cast. The specific working principle thereof is to be described in the following embodiments:
In the technical solution provided by embodiments of the present application, an active layer and multiple metal layers are stacked on a substrate. The multiple metal layers at least include a first metal wire extending in a first direction and a second metal wire extending in a second direction. The first metal wire and the second metal wire are located in different layers. A first initialization transistor is connected between the first metal wire and a gate of a drive transistor and is configured to transmit a first initialization voltage on the first metal wire to the gate of the drive transistor. A second initialization transistor is connected between the second metal wire and a light-emitting element and is configured to transmit a second initialization voltage on the second metal wire to the light-emitting element. In the technical solution provided by embodiments of the present application, the first metal wire and the second metal wire are configured in different layers so that corresponding initialization voltages can be provided to the first initialization transistor and the second initialization transistor to adjust the potential state of the gate of the drive transistor and of the anode of the light-emitting element. In this manner, the stability of the drive current is enhanced, and the uniformity of display brightness and display color cast are improved. Additionally, the first metal wire and the second metal wire are configured in different layers in a limited layout space so that the layout space utilization can be enhanced, the layout structure can be optimized, and the display PPI can be improved.

With continued reference to FIG. 1, the first metal wire 11 includes multiple first sub-metal wires 111 and multiple second sub-metal wires 112 that are arranged in multiple columns; each of the multiple first sub-metal wires 111 is disposed in a column, and part of the multiple second sub-metal wires 112 are arranged in a column; the first initialization transistor T2 is connected between corresponding one of the multiple first sub-metal wires 111 and the gate of the drive transistor T1; the second initialization transistor T3 is connected to corresponding one of the multiple second sub-metal wires 112.

The multiple metal layers also include a third metal wire 13 and a fourth metal wire 14, which are a first scan line and a second scan line, respectively. The third metal wire 13 and the fourth metal wire 14 separately extend in the second direction. The orthographic projection of the second metal wire 12 on the substrate 21 is located between the orthographic projection of the third metal wire 13 on the substrate 21 and the orthographic projection of the fourth metal wire 14 on the substrate 21. The third metal wire 13 and the fourth metal wire 14 may both be located on the first metal layer. The third metal wire 13 overlaps the active layer 10 to form the first initialization transistor T2. The fourth metal wire 14 overlaps the active layer 10 to form the second initialization transistor T3. Here, the transistor formed by the overlap of the third metal wire 13 and the active layer 10 is configured as a second initialization transistor T3 in the previous row of pixel circuits adjacent to the current row of pixel circuits.

For example, a single first sub-metal wire 111 is arranged in a column in the first direction, multiple second sub-metal wires 112 are arranged in a column in the first direction, and the multiple first sub-metal wires 111 and the multiple second sub-metal wires 112 are insulated from each other. A first terminal of the first initialization transistor T2 is connected to the first sub-metal wire 111. A second terminal of the first initialization transistor T2 is connected to the gate of the drive transistor T1. The first sub-metal wire 111 is configured to supply the first initialization voltage Vrefl to the first initialization transistor T2. A first terminal of the second initialization transistor T3 is connected to a first terminal of the second sub-metal wire 112. A second terminal of the second sub-metal wire 112 is connected to the second metal wire 12. A second terminal of the second initialization transistor T3 is connected to the anode of the light-emitting element D1. Here, the second sub-metal wire 112 serves as a connection to transmit the second initialization voltage Vref2 provided by the second metal wire 12 to the first terminal of the second initialization transistor T3.

Since the first metal wire 11 and the second metal wire 12 are disposed in different layers, the first initialization voltage Vrefl on the first metal wire 11 and the second initialization voltage Vref2 on the second metal wire 12 may be different. Illustratively, the first initialization voltage Vrefl in this embodiment may be smaller than the second initialization voltage Vref2. Since the first initialization voltage Vrefl is smaller, it is possible to pull the gate voltage of the drive transistor T1 to a lower potential so that the gate potential of the drive transistor T1 is completely reset. For different pixel circuits, it is possible to ensure that the data voltage can be completely written into the gate of the drive transistor T1, thereby enhancing the threshold compensation effect on the drive transistor T1, improving the uniformity of the drive current, and improving residual shadows. When the light-emitting element D1 anode is initialized, the second initialization voltage Vref2 is appropriately increased so that the effect of the parasitic capacitance of the light-emitting element D1 on the drive current can be reduced, and then the color cast caused by brightness deviation can be reduced.

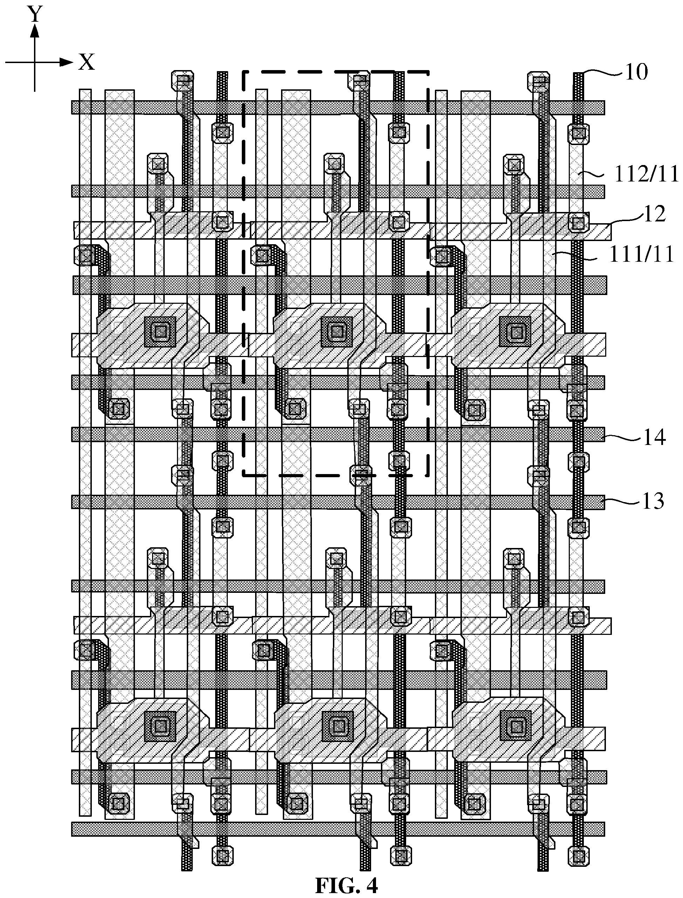

For example, FIG. 4 is a top view illustrating the structure of another array substrate according to an embodiment of the present application, specifically illustrating a partial structure of an array pixel circuit. With reference to FIGS. 1 and 4, the first sub-metal wire 111 extends in the Y direction and is connected to the first sub-metal wire 111 of the pixel circuits corresponding to the upper and lower rows to form a vertical line. Each first sub-metal wire 111 is arranged in a column. The second metal wire 12 extends in the X direction and is connected to the second metal wire 12 of the pixel circuits corresponding to the left and right columns to form a horizontal line. The second sub-metal wire 112 extends in the Y direction and is connected to the second metal wire 12 and connected to the second initialization transistor T3 via the active layer 10. Thus, multiple second sub-metal wires 112 are arranged in a column. The specific structure of a single pixel circuit is shown in the dashed box.

In this embodiment, the third metal wire 13 or the fourth metal wire 14 corresponding to the pixel circuits in two adjacent rows may be shared. That is, the fourth metal wire 14 corresponding to a pixel circuit in an nth row may be reused as the third metal wire 13 corresponding to a pixel circuit in an (n + 1)th row, where n is an integer greater than or equal to 1. For example, the fourth metal wire 14 of a pixel circuit in an nth row is reused as the third metal wire 13 of a pixel circuit in an (n + 1)th row. That is, the second scan line in an nth row is used as the first scan line in an (n + 1)th row, which saves layout space and results in a higher PPI.

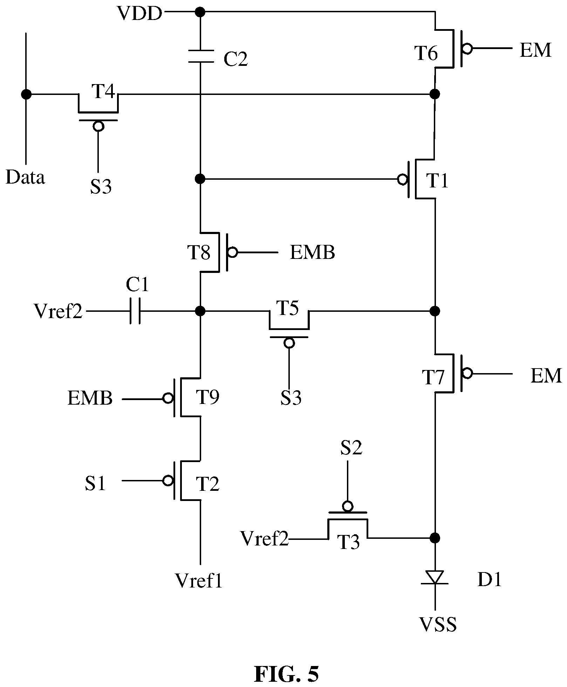

FIG. 5 is a schematic diagram illustrating the structure of another pixel circuit according to an embodiment of the present application. With reference to FIG. 5, a pixel circuit of the multiple pixel circuits also includes a first leakage compensation transistor T8 and a second leakage compensation transistor T9, the first leakage compensation transistor T8 is connected between the gate of the drive transistor T1 and a second electrode of the second leakage compensation transistor T9, and a first electrode of the second leakage compensation transistor T9 is connected to the first initialization transistor T2. A gate of the first leakage compensation transistor T8 and a gate of the second leakage compensation transistor T9 are connected to the same scan line and are configured to turn off the leakage path of the drive transistor T1 when the data writing is completed so as to reduce the leakage current and maintain the stability of the gate potential of drive transistor T1.

With continued reference to FIG. 5, the pixel circuit of the multiple pixel circuits also includes a first storage capacitor C1; the first storage capacitor C1 is connected to the second electrode of the second leakage compensation transistor T9 and is configured to store the potential of the second electrode of the second leakage compensation transistor T9. For example, when the first leakage compensation transistor T8 changes from being turned on to being turned off, the parasitic capacitance between the gate of the first leakage compensation transistor T8 and the gate of the drive transistor T1 is coupled, and couples the gate potential of the drive transistor T1 so that the gate potential of the drive transistor T1 is similar to the first electrode potential of the first leakage compensation transistor T8 (the gate of the drive transistor T1 is connected to the second electrode of the first leakage compensation transistor T8, and the first electrode of the first leakage compensation transistor T8 is connected to the second electrode of the second leakage compensation transistor T9). Therefore, the voltage difference between the first electrode and the second electrode of the first leakage compensation transistor T8 is smaller so that the leakage current of the first leakage compensation transistor T8 is smaller, which helps maintain the stability of the gate potential of drive transistor T1.

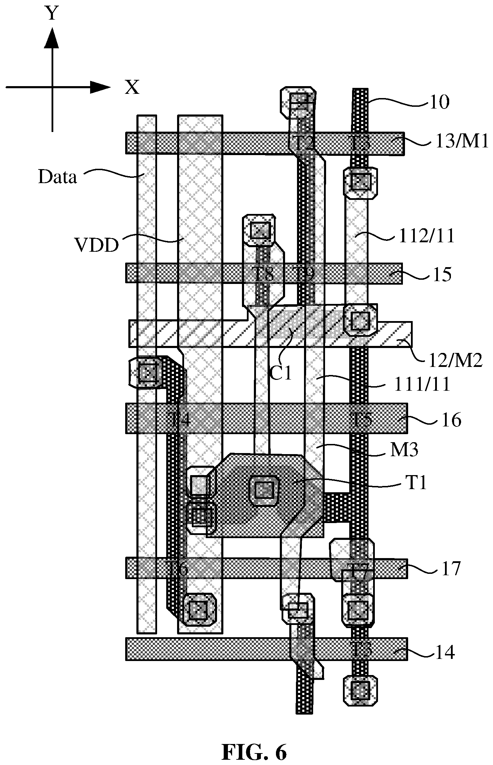

FIG. 6 is a top view illustrating the structure of another array substrate according to an embodiment of the present application. A second storage capacitor C2 is not shown in FIG. 6. With reference to FIGS. 5 and 6, the multiple metal layers include a first metal layer M1, a second metal layer M2, and a third metal layer M3; the first metal layer M1 includes the gate of the drive transistor T1, the third metal wire 13, and the fourth metal wire 14, the second metal layer M2 includes the second metal wire 12, and the third metal layer M3 includes the first metal wire 11. The multiple metal layers also include a fifth metal wire 15 serving as a third scan line EMB. The fifth metal wire 15 is not disposed in the same layer as the first metal wire 11 and the second metal wire 12. For example, the fifth metal wire 15 is located at the first metal layer M1. The orthographic projection of the fifth metal wire 15 on the substrate is located on one side of the orthographic projection of the second metal wire 12 on the substrate and does not overlap the orthographic projection of the second metal wire 12 on the substrate, that is, the orthographic projection of the fifth metal wire 15 on the substrate is staggered with the orthographic projection of the second metal wire 12 on the substrate. The fifth metal wire 15 overlaps the active layer 10 to form the first leakage compensation transistor T8 and the second leakage compensation transistor T9. The second metal wire 12 is connected to the first storage capacitor C1 that may be formed by the overlap of the second metal wire 12 and the active layer 10, which helps save layout space.

With continued reference to FIGS. 5 and 6, the multiple metal layers also include a sixth metal wire 16 extending in the second direction and a seventh metal wire 17 extending in the second direction, and the sixth metal wire 16 and the seventh metal wire 17 are a fourth scan line S3 and a fifth scan line Em, respectively. The sixth metal wire 16 overlaps the active layer 10 to form a data writing transistor T4 and a threshold compensation transistor T5. The seventh metal wire 17 overlaps the active layer 10 to form a first light-emitting control transistor T6 and a second light-emitting control transistor T7. The active layer 10 overlapping the sixth metal wire 16 to form the data writing transistor T4 is connected to the data line Data through a via. The active layer 10 overlapping the seventh metal wire 17 to form the first light-emitting control transistor T6 is connected to a first power supply line VDD through a via (a second power supply line VSS is not shown in the figure).

In the preceding embodiments, no electrical connection exists between the first metal wire 11 and the second metal wire 12, that is, the first sub-metal wire 111 and the second sub-metal wire 112 are insulated from each other, and the first initialization voltage Vrefl and the second initialization voltage Vref2 can be adjusted separately.

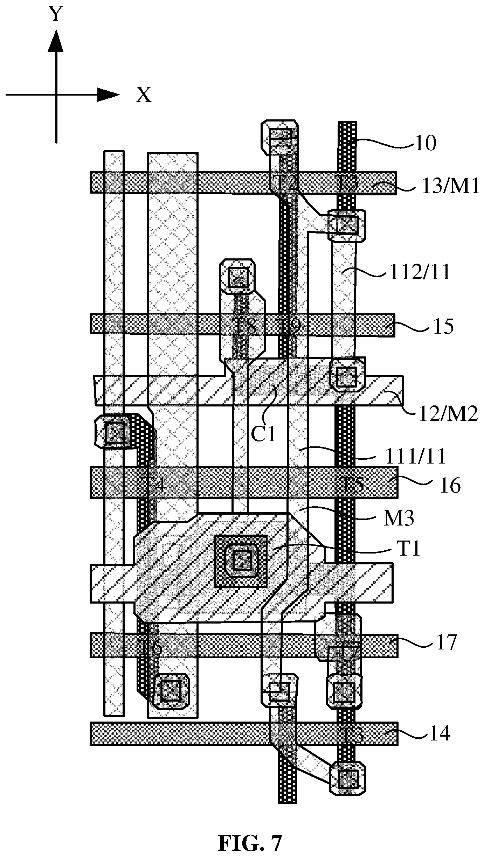

Of course, the first metal wire 11 and the second metal wire 12 may also be connected together to form a mesh structure. FIG. 7 is a top view illustrating the structure of another array substrate according to an embodiment of the present application. Based on the preceding multiple technical solutions, reference is made to FIG. 7. For example, the multiple second sub-metal wires 112 and the multiple first sub-metal wires 111 are connected to form a mesh. That is, the multiple first sub-metal wires 111 and the multiple second sub-metal wires 112 are connected together. Since the second sub-metal wire 112 is also connected to the second metal wire 12, the first metal wire 11 and the second metal wire 12 are connected to each other form a horizontal and vertical mesh structure. At this time, the first initialization voltage Vrefl is equal to the second initialization voltage Vrefl, that is, the second initialization voltage Vref2 may also be used as the first initialization voltage Vrefl.

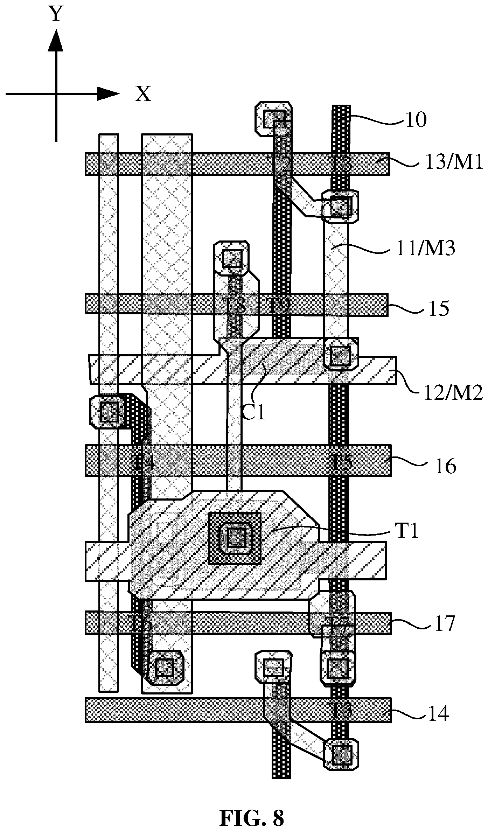

FIG. 8 is a top view illustrating the structure of another array substrate according to an embodiment of the present application. With reference to FIGS. 5 and 8, for example, a first terminal of the first metal wire 11 is connected to the second metal wire 12, and a second terminal of the first metal wire 11 is connected to the first initialization transistor T2 and the second initialization transistor T3. Unlike the layout structure shown in FIG. 7, the layout structure shown in FIG. 8 does not have a first sub-metal wire 111. The second metal wire 12 is connected to the first initialization transistor T2 and the second initialization transistor T3 via the first metal wire 11, that is, the first initialization transistor T2 and the second initialization transistor T3 are indirectly connected to the second metal wire 12 via the first metal wire 11, and the second initialization voltage Vref2 on the second metal wire 12 is transmitted to the gate of the drive transistor T1 and the anode of the light-emitting element D1 via the first initialization transistor T2 and the second initialization transistor T3, respectively. At this time, the second initialization voltage Vref2 is the first initialization voltage Vrefl. In this embodiment, since no vertical line (first sub-metal wire 111) exists for transmitting the first initialization voltage Vrefl, a larger light transmittance can be obtained.

The positions of multiple transistors in FIG. 8 are the same as those in FIG. 6, and details are not repeated herein.

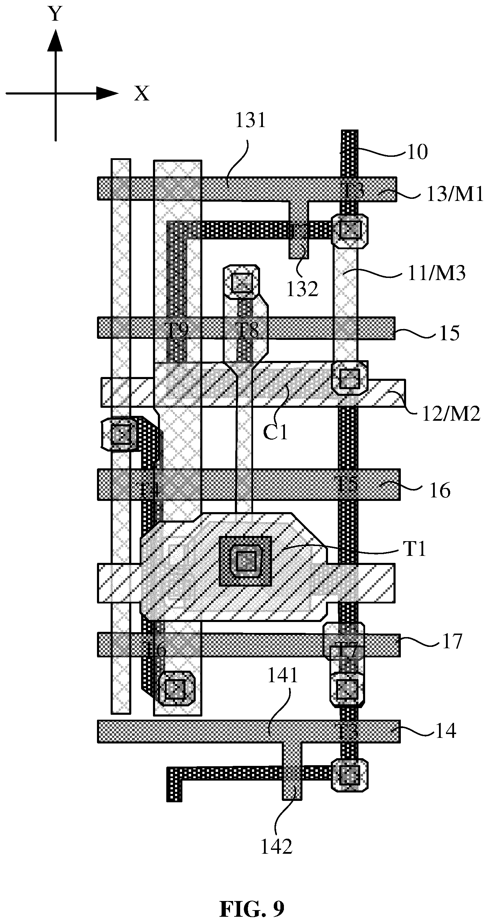

FIG. 9 is a top view illustrating the structure of another array substrate according to an embodiment of the present application. The layout structure shown in FIG. 9 differs from the layout structure shown in FIG. 8 in that the structure of active layer 10 is different. With reference to FIG. 9, the second leakage compensation transistor T9 is formed on the left side of the first leakage compensation transistor T8. The third metal wire 13 includes a first body portion 131 and a first branch portion 132. The fourth metal wire 14 includes a second body portion 141 and a second branch portion 142. The first body portion 131 and the second body portion 141 extend in the second direction. The first branch portion 132 and the second branch portion 142 extend in the first direction. The active layer 10 forming the second leakage compensation transistor T9 extends upward in the first direction and then extends in the second direction to overlap the first branch portion 132 of the third metal wire 13 to form the first initialization transistor T2. The first body portion 131 of the third metal wire 13 overlaps the active layer 10 to form the second initialization transistor T3 of the pixel circuit in the previous row. The second body portion 141 of the fourth metal wire 14 overlaps the active layer 10 extending in the first direction to form the second initialization transistor T3 of the pixel circuit in the current row. The second branch portion 142 of the fourth metal wire 14 overlaps the active layer 10 extending in the second direction to form the first initialization transistor T2 of the pixel circuit in the next row. The principle of the pixel circuit shown in FIG. 9 is the same as that of the pixel circuit shown in FIGS. 8 and 6, and the specific working process thereof is to be described in detail in the following description:
In the preceding technical solutions, the orthographic projection of the second metal wire 12 on the substrate 21 is located between the orthographic projection of the fifth metal wire 15 on the substrate 21 and the orthographic projection of the sixth metal wire 16 on the substrate 21, and the fifth metal wire 15 is located on a side of the second metal wire 12 facing away from the drive transistor T1.

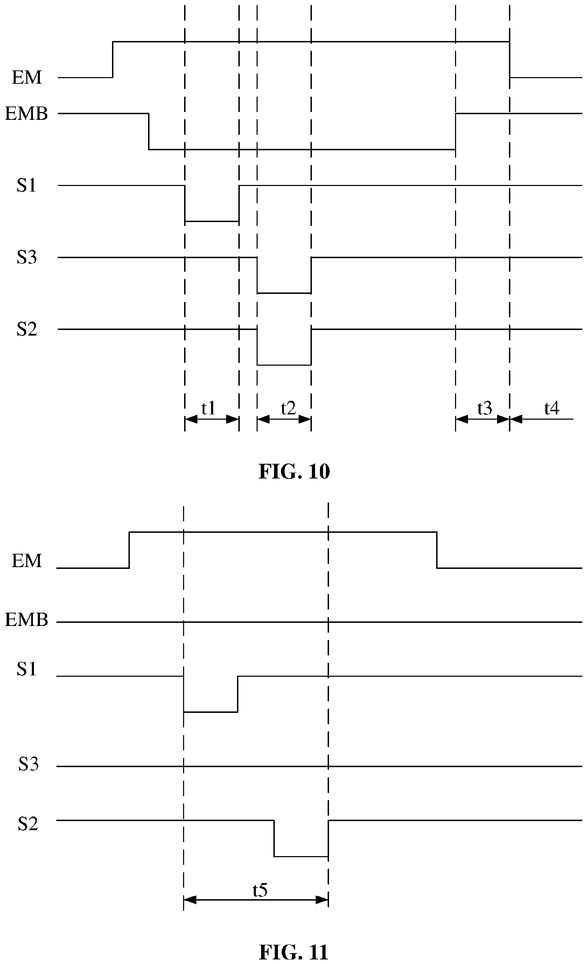

FIG. 10 is a drive timing waveform diagram of a pixel circuit according to an embodiment of the present application. FIG. 11 is a drive timing waveform diagram of another pixel circuit according to an embodiment of the present application, which is applicable to the pixel circuit shown in FIG. 5. FIG. 11 specifically shows the drive timing of a black frame insertion stage. With reference to FIG. 5, FIG. 10, and FIG. 11, this embodiment is only described by using an example where multiple transistors are P-type transistors. In other embodiments, the multiple transistors may be N-type transistors. The working process of the pixel circuit provided by this embodiment of the present application includes at least an initialization stage 11, a data writing stage t2, a voltage normalization stage t3, a light-emitting stage t4, and a black frame insertion stage t5.

At the initialization stage 11, a first scan signal transmitted on the first scan line S1 is a low level, a second scan signal transmitted on the second scan line S2 is a high level, a third scan signal transmitted on the third scan line EMB is a low level, a fourth scan signal transmitted on the fourth scan line S3 is a high level, and a fifth scan signal transmitted on the fifth scan line EM is a high level. Therefore, the first initialization transistor T2, the first leakage compensation transistor T8, and the second leakage compensation transistor T9 are turned on, and the first initialization voltage Vrefl is transmitted to the gate of the drive transistor T1 to initialize the gate potential of the drive transistor T1.

At the data writing stage t2, a first scan signal transmitted on the first scan line S1 is a high level, a second scan signal transmitted on the second scan line S2 is a low level, a third scan signal transmitted on the third scan line EMB is a low level, a fourth scan signal transmitted on the fourth scan line S3 is a low level, and a fifth scan signal transmitted on the fifth scan line EM is a high level. Therefore, the data writing transistor T4, the threshold compensation transistor T5, the second initialization transistor T3, the first leakage compensation transistor T8, and the second leakage compensation transistor T9 are turned on, and the data voltage on the data line Data is written into the gate of the drive transistor T1. When the gate voltage of drive transistor T1 reaches (Vdata + Vth), the drive transistor T1 is turned off, and the voltage is stored on the first storage capacitor C1 and the second storage capacitor C2, where Vdata is the data voltage, and Vth is the threshold voltage of the drive transistor. Meanwhile, the second initialization voltage Vref2 is written into the anode of the light-emitting element D1 via the second initialization transistor T3 to initialize the anode potential of the light-emitting element D1. At this time, the gate voltage of the drive transistor T1 is not equal to the storage voltage on the first storage capacitor C1.

At the voltage normalization stage t3, the third scan signal transmitted on the third scan line EMB jumps from a low level to a high level, and under the coupling effect of the parasitic capacitance of the gate of the drive transistor T1, the gate voltage of the drive transistor T1 is pulled up to be close to the voltage stored on the first storage capacitor C1 so that the voltage difference between the first electrode and the second electrode of the first leakage compensation transistor T8 is smaller. Thus, the leakage current of the first leakage compensation transistor T8 is smaller, and the gate voltage of the drive transistor T1 can be maintained stable.

At the light-emitting stage t4, the first scan signal transmitted on the first scan line S1 is a high level, the second scan signal transmitted on the second scan line S2 is a high level, the third scan signal transmitted on the third scan line EMB is a high level, the fourth scan signal transmitted on the fourth scan line S3 is a high level, and the fifth scan signal transmitted on the fifth scan line EM is a low level. Therefore, the first light-emitting control transistor T6 and the second light-emitting control transistor T7 are turned on, and the drive transistor T1 generates a drive current to drive the light-emitting element D1 to emit light. Since the gate voltage of drive transistor T1 can be maintained stable for a long time, the uniformity of the drive current can be ensured, and the residual shadows of display pictures can be improved.

When the fifth scan signal transmitted on the fifth scan line EM jumps from a low level to a high level, the pixel circuit enters the black frame insertion stage t5. At the black frame insertion stage t5, the third scan signal transmitted on the third scan line EMB is always a high level, and the first leakage compensation transistor T8 and the second leakage compensation transistor T9 are in an off state.

The fourth scan signal transmitted on the fourth scan line S3 maintains a high level, and the low level of the first scan signal transmitted on the first scan line S1 and the low level of the second scan signal transmitted on the second scan line S2 arrive successively. Since the first leakage compensation transistor T8 and the second leakage compensation transistor T9 are in the off state, the first initialization voltage Vrefl is not written into the gate of the drive transistor T1, and only the second initialization voltage Vref2 is written into the anode of the light-emitting element D 1 to reset the anode potential of the light-emitting element D 1.

When the black frame insertion stage t5 ends, the fifth scan signal transmitted on the fifth scan line EM jumps from a high level to a low level, and the light-emitting element D1 continues to emit light.

In this embodiment, the black frame insertion stage may be performed multiple times; the black frame insertion stage is configured and the anode potential of the light-emitting element D1 is reset at the black frame insertion stage so that a low-frequency brightness component that is easily perceived by human eyes can be completely converted into a high-frequency brightness component that is not easily perceived, thereby improving the flickering of the display pictures.

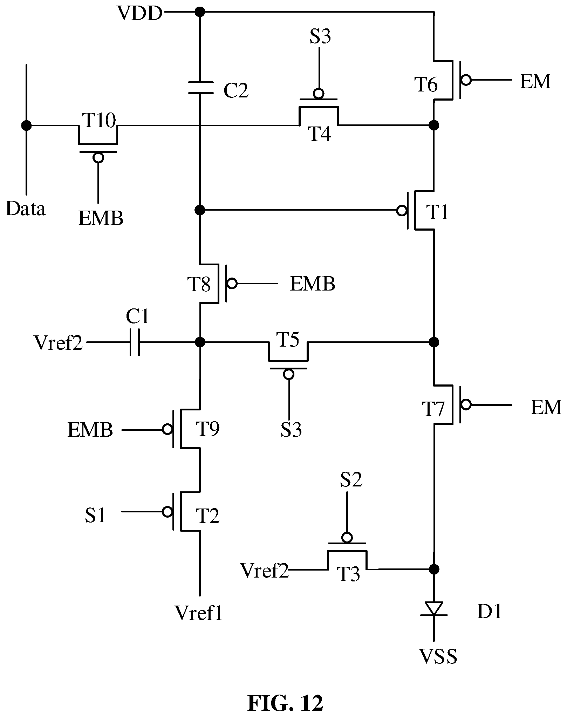

FIG. 12 is a schematic diagram illustrating the structure of another pixel circuit according to an embodiment of the present application. With reference to FIG. 12, based on the preceding multiple technical solutions, for example, a pixel circuit of the multiple pixel circuits also includes a first voltage writing control transistor T10, the first voltage writing control transistor T10 and the data writing transistor T4 are connected in series between the data line Data and the first electrode of the drive transistor T1, and a gate of the first voltage writing control transistor T10 is connected to the third scan signal transmitted on the third scan line EMB.

When the parasitic capacitance at the first and second electrodes of the drive transistor T1 is smaller, the pixel circuit shown in FIG. 12 may be driven using the drive timing shown in FIG. 11. Here, the fourth scan signal transmitted on the fourth scan line S3 and the second scan signal transmitted on the second scan line S2 may be configured to be the same so that the fourth scan signal transmitted on the fourth scan line S3 also has a pulse within the black frame insertion stage t5. Thus, the scan frequency of the fourth scan signal transmitted on the fourth scan line S3 is increased. In this embodiment, the scan frequency of the scan signal connected to the gate of the data writing transistor T4, the scan frequency of the scan signal connected to a gate of the first initialization transistor T2, and the scan frequency of the scan signal connected to a gate of the second initialization transistor T3 are all higher than a preset high scan frequency. The preset high scan frequency may be 60 Hz, and signals whose scan frequency is higher than the preset high scan frequency are high frequency signals. In other words, the scan signals on the first scan line S1, the second scan line S2, and the fourth scan line S3 are high frequency signals.

Of course, in other embodiments, the preset high scan frequency may also be 75 Hz, 100 Hz, or 120 Hz, which is not specifically limited in this embodiment.

At the black frame insertion stage t5, since the first voltage writing control transistor T10 is turned off, even if the threshold compensation transistor T5 and the data writing transistor T4 are turned on in response to the fourth scan signal, the voltage of the first electrode of the first leakage compensation transistor T8 does not change greatly, and a smaller voltage difference can still be maintained between the second electrode and the first electrode of the first leakage compensation transistor T8. Therefore, the first leakage compensation transistor T8 can maintain a low leakage current. Since the fourth scan signal transmitted on the fourth scan line S3, the first scan signal transmitted on the first scan line S1, and the second scan signal transmitted on the second scan line S2 are all high frequency signals, the first scan signal, the second scan signal, and the fourth scan signal may be generated by the same set of gate drive circuits, which facilitates a narrow frame design.

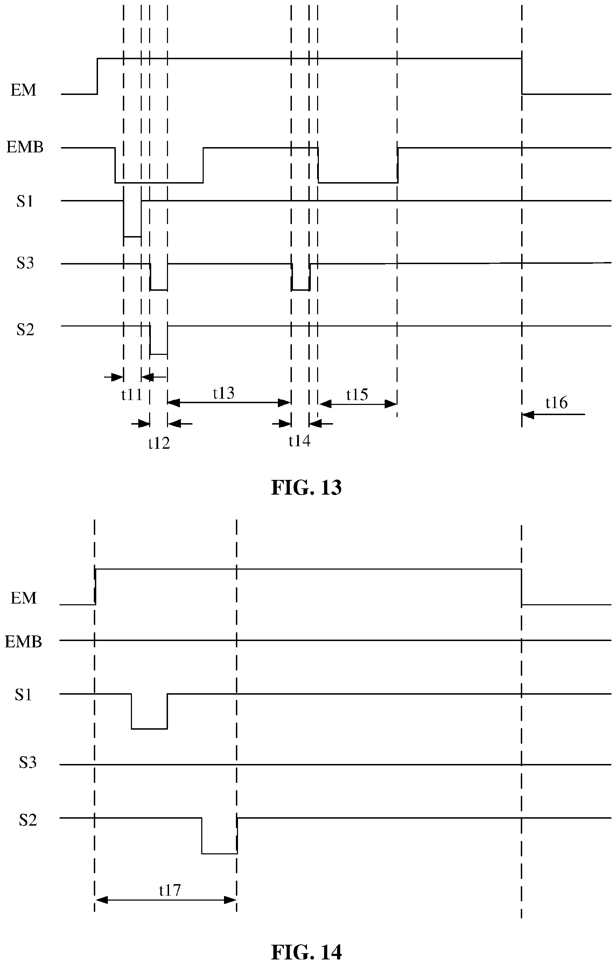

When the parasitic capacitance at the first electrode and the second electrode of the drive transistor T1 is larger, the sub-threshold of the drive transistor T1 may be compensated in a dual-pulse drive manner. FIG. 13 is a drive timing waveform diagram of another pixel circuit according to an embodiment of the present application. FIG. 14 is a drive timing waveform diagram of another pixel circuit according to an embodiment of the present application, which specifically illustrates the drive timing of the black frame insertion stage. The drive timings shown in FIGS. 13 and 14 are applicable to the pixel circuit shown in FIG. 12. The working process of the pixel circuit includes stages described below.

At the first stage 111 (corresponding to the initialization stage), a first scan signal transmitted on the first scan line S1 is a low level, a second scan signal transmitted on the second scan line S2 is a high level, a third scan signal transmitted on the third scan line EMB is a low level, a fourth scan signal transmitted on the fourth scan line S3 is a high level, and a fifth scan signal transmitted on the fifth scan line EM is a high level. Therefore, the first initialization transistor T2, the first leakage compensation transistor T8, and the second leakage compensation transistor T9 are turned on, and the first initialization voltage Vrefl is transmitted to the gate of the drive transistor T1 to initialize the gate potential of the drive transistor T1.

At the second stage 112 (corresponding to the data writing stage), a first scan signal transmitted on the first scan line S1 is a high level, a second scan signal transmitted on the second scan line S2 is a low level, a third scan signal transmitted on the third scan line EMB is a low level, a fourth scan signal transmitted on the fourth scan line S3 is a low level, and a fifth scan signal transmitted on the fifth scan line EM is a high level. Therefore, the data writing transistor T4, the threshold compensation transistor T5, the second initialization transistor T3, the first voltage writing control transistor T10, the first leakage compensation transistor T8, and the second leakage compensation transistor T9 are turned on, and a voltage related to the data voltage on the data line Data is written into the gate of the drive transistor T1. When the gate voltage of drive transistor T1 reaches (Vdata + Vth), the drive transistor T1 is turned off, and the voltage is stored on the first storage capacitor C1 and the second storage capacitor C2, where Vdata is the data voltage, and Vth is the threshold voltage of the drive transistor. Meanwhile, the second initialization voltage Vref2 is written into the anode of the light-emitting element D1 via the second initialization transistor T3 to initialize the anode potential of the light-emitting element D1. At this time, the gate voltage of the drive transistor T1 is close to the storage voltage on the first storage capacitor C1.

At the third stage t13, the first scan signal transmitted on the first scan line S1 is a high level, the second scan signal transmitted on the second scan line S2 is a high level, the fourth scan signal transmitted on the fourth scan line S3 is a high level, and the fifth scan signal transmitted on the fifth scan line EM is a high level. When the third scan signal transmitted on the third scan line EMB changes to a high level, the first voltage writing control transistor T10 is turned off, and the data voltage stored in the first electrode of the drive transistor T1 continues to charge the second electrode. After a period of time, the drive transistor T1 enters a sub-threshold region. The larger the sub-threshold swing of the drive transistor T1 is, the higher the voltage of the second electrode of the drive transistor T1 is.

At the fourth stage t14, the first scan signal transmitted on the first scan line S1 is a high level, the second scan signal transmitted on the second scan line S2 is a high level, the third scan signal transmitted on the third scan line EMB is a high level, the fourth scan signal transmitted on the fourth scan line S3 is a low level, and the fifth scan signal transmitted on the fifth scan line EM is a high level. Therefore, the data writing transistor T4 and the threshold compensation transistor T5 are turned on, and the second electrode of the drive transistor T1 is connected to the first electrode of the first leakage compensation transistor T8. At this time, since the first voltage writing control transistor T10 is turned off, the data voltage on the data line Data is not written into the drive transistor T1.

At the fifth stage t15, the first scan signal transmitted on the first scan line S1 is a high level, the second scan signal transmitted on the second scan line S2 is a high level, the third scan signal transmitted on the third scan line EMB is a low level, the fourth scan signal transmitted on the fourth scan line S3 is a high level, and the fifth scan signal transmitted on the fifth scan line EM is a high level. Therefore, the first voltage writing control transistor T10, the first leakage compensation transistor T8, and the second leakage compensation transistor T9 are turned on, and the gate of the drive transistor T1 is connected to the first electrode of the first leakage compensation transistor T8. Finally, the gate voltage of the drive transistor T1 increases slightly as the sub-threshold swing of the drive transistor T1 increases, which can compensate for the sub-threshold swing and thus improve the uneven display under low grayscale.

At the sixth stage t16 (corresponding to the light-emitting stage), the first scan signal transmitted on the first scan line S1 is a high level, the second scan signal transmitted on the second scan line S2 is a high level, the third scan signal transmitted on the third scan line EMB is a high level, the fourth scan signal transmitted on the fourth scan line S3 is a high level, and the fifth scan signal transmitted on the fifth scan line EM is a low level. Therefore, the first light-emitting control transistor T6 and the second light-emitting control transistor T7 are turned on, and the drive transistor T1 generates a drive current to drive the light-emitting element D1 to emit light.

When the fifth scan signal transmitted on the fifth scan line EM changes from a low level to a high level, the light-emitting element D1 goes out, and the pixel circuit enters the seventh stage t17 (corresponding to the black frame insertion stage). The fourth scan signal transmitted on the fourth scan line S3 maintains a high level, and the low level of the first scan signal transmitted on the first scan line S1 and the low level of the second scan signal transmitted on the second scan line S2 arrive successively. When the first scan signal is a low level, the first initialization transistor T2 is turned on. However, since the second leakage compensation transistor T9 and the first leakage compensation transistor T8 are turned off, the first initialization voltage Vrefl is not transmitted to the gate of the drive transistor T1, which does affect the normal operation of the pixel circuit. When the second scan signal is a low level, the second initialization transistor T3 is turned on, and the second initialization voltage Vref2 is transmitted to the anode of the light-emitting element D1 to initialize the anode potential of the light-emitting element D1.

When the black frame insertion stage ends, the fifth scan signal transmitted on the fifth scan line EM changes from a high level to a low level, and the light-emitting element D1 continues to emit light.

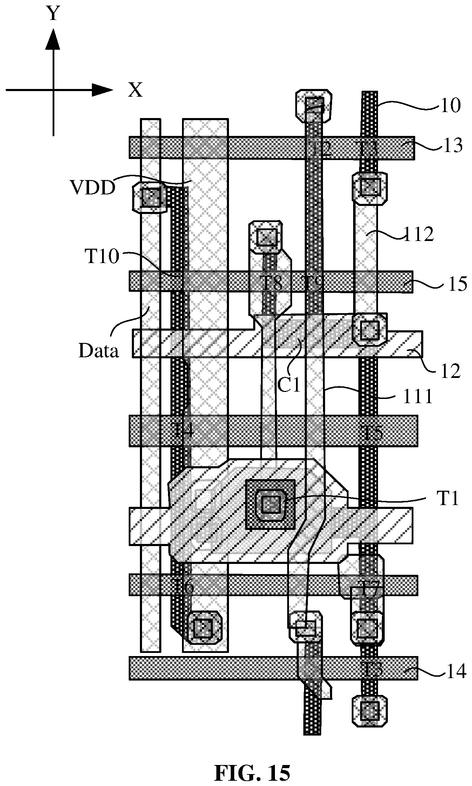

FIG. 15 is a top view illustrating the structure of another array substrate according to an embodiment of the present application. For example, FIG. 15 is a top structural view corresponding to the pixel circuit shown in FIG. 12. With reference to FIG. 15, the active layer 10 forming the data writing transistor T4 extends upward in the first direction and overlaps the fifth metal wire 15 to form the first voltage writing control transistor T10, and the active layer 10 is connected to the data line Data through a via. The connection structure of the other multiple transistors is the same as the layout structure of the pixel circuit shown in FIG. 6, and details are not repeated herein.

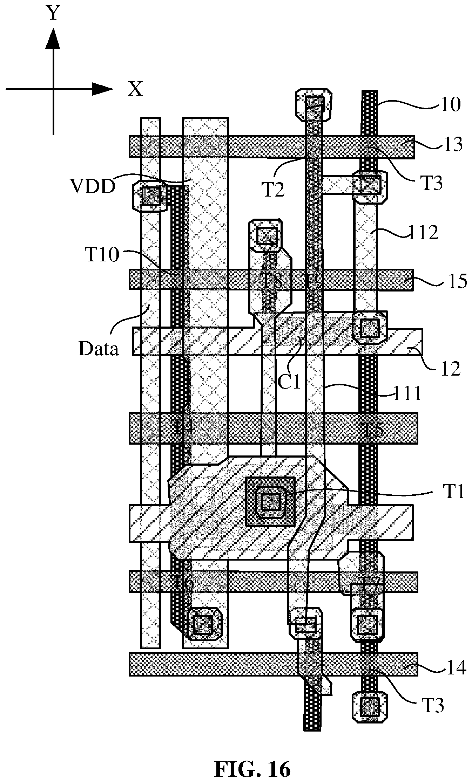

FIG. 16 is a top view illustrating the structure of another array substrate according to an embodiment of the present application. Based on the layout structure shown in FIG. 15, the first sub-metal wire 111 and the second sub-metal wire 112 may be connected together to form a mesh structure, which facilitates the transmission of signals. Of course, the second metal wire 12 is connected to the first initialization transistor T2 and the second initialization transistor T3 via the first metal wire 11. That is, the first initialization transistor T2 and the second initialization transistor T3 are indirectly connected to the second metal wire 12 via the first metal wire 11, and the second initialization voltage Vref2 on the second metal wire 12 is transmitted to the gate of the drive transistor T1 and the anode of the light-emitting element D1 via the first initialization transistor T2 and the second initialization transistor T3, respectively. Since no vertical line (first sub-metal wire 111) exists for transmitting the first initialization voltage Vrefl, a larger light transmittance can be obtained. For the specific connection structure, reference may be made to the layout structure shown in FIG. 8.

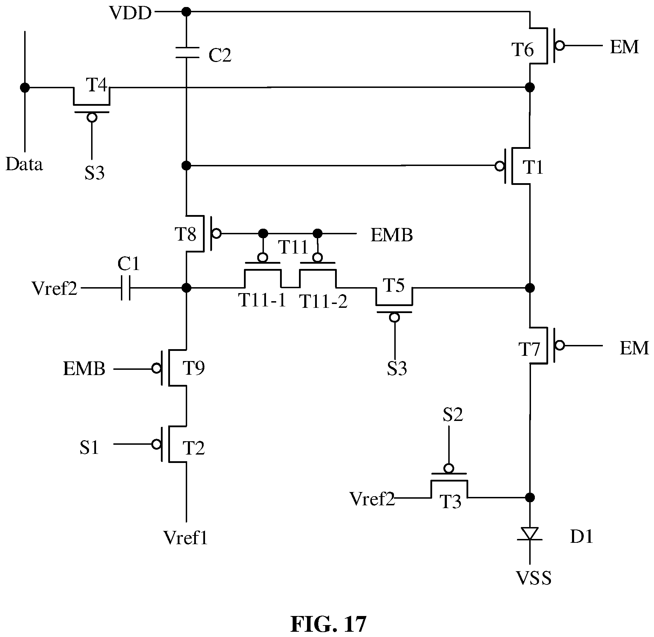

FIG. 17 is a schematic diagram illustrating the structure of another pixel circuit according to an embodiment of the present application. With reference to FIG. 17, based on the preceding multiple technical solutions, for example, the pixel circuit of the multiple pixel circuits also includes a second voltage writing control transistor T11 connected between a second electrode of the drive transistor T1 and the second electrode of the second leakage compensation transistor T9. The second voltage writing control transistor T11 may be a double-gate transistor or a single-gate transistor.

In this embodiment, the second voltage writing control transistor T11 and the first leakage compensation transistor T8 are connected to the same scan signal. Therefore, the pixel circuit is also applicable to the drive timings shown in FIGS. 10 and 11 and also applicable to the drive timings shown in FIGS. 13 and 14. Additionally, the second voltage writing control transistor T11 and the threshold compensation transistor T5 are connected in series. Thus, at the black frame insertion stage, since the fifth scan signal transmitted on the fifth scan line EM is always a high level, and the second voltage writing control transistor T11, the second leakage compensation transistor T9, and the first leakage compensation transistor T8 are always in the off state, the data voltage is not written into the gate of the drive transistor T1 even if the data writing transistor T2 and the threshold compensation transistor T5 are turned on. In this manner, the normal operation of the pixel circuit is ensured. Therefore, the second scan signal transmitted on the second scan line S2 may be configured as a high-frequency signal, and the second scan signal, the first scan signal, and the fourth scan signal may be generated by the same set of gate drive circuits, which facilitates a narrow frame design.

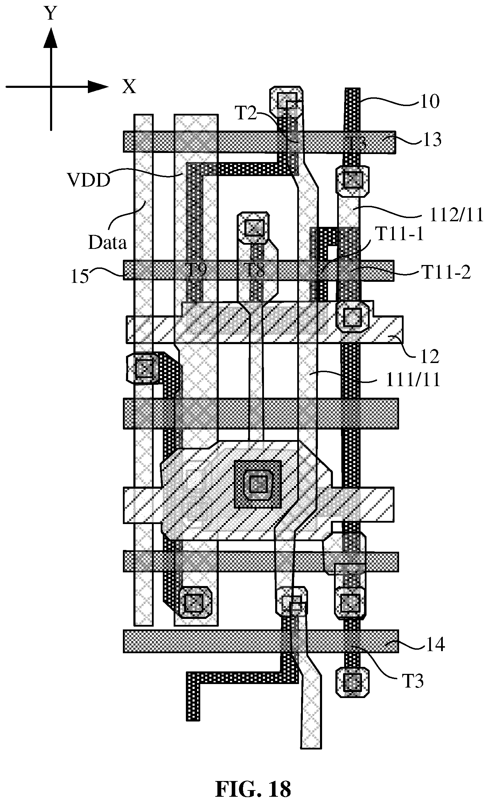

FIG. 18 is a schematic diagram illustrating the structure of another array substrate according to an embodiment of the present application. For example, FIG. 18 shows a layout structure corresponding to the pixel circuit shown in FIG. 17. With reference to FIG. 18, the structure of the active layer 10 is optimized, and the active layer 10 overlapping the second metal wire 12 extends in the first direction and overlaps the fifth metal wire 15 such that the overlapping portion of the fifth metal wire 15 and the active layer 10 forms the second voltage writing control transistor T11 (including a first sub-transistor T11-1 and a second sub-transistor T11-2), the first leakage compensation transistor T8, and the second leakage compensation transistor T9. In a limited space, the space utilization of the layout is improved.

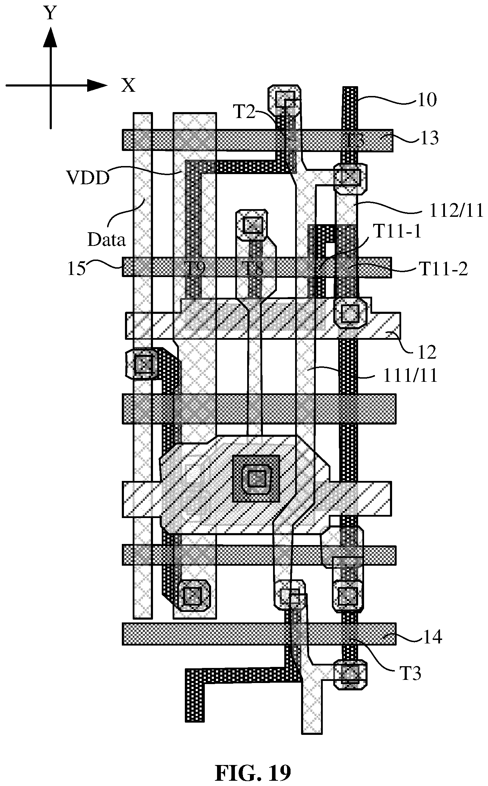

FIG. 19 is a schematic diagram illustrating the structure of another array substrate according to an embodiment of the present application. For example, FIG. 19 shows another layout structure corresponding to the pixel circuit shown in FIG. 17. With reference to FIG. 19, the first sub-metal wire 111 and the second sub-metal wire 112 are connected together, and since the second sub-metal wire 112 is also connected to the second metal wire 12, the first metal wire 11 and the second metal wire 12 are connected to each other to form a horizontal and vertical mesh structure. At this time, although the first initialization voltage Vrefl and the second initialization voltage Vref2 cannot be adjusted separately, the threshold compensation effect of the drive transistor T1 may be improved by drive timing (such as double pulse timing as shown in FIG. 13). Thus, the non-uniformity of the drive current is improved to enhance the display effect.

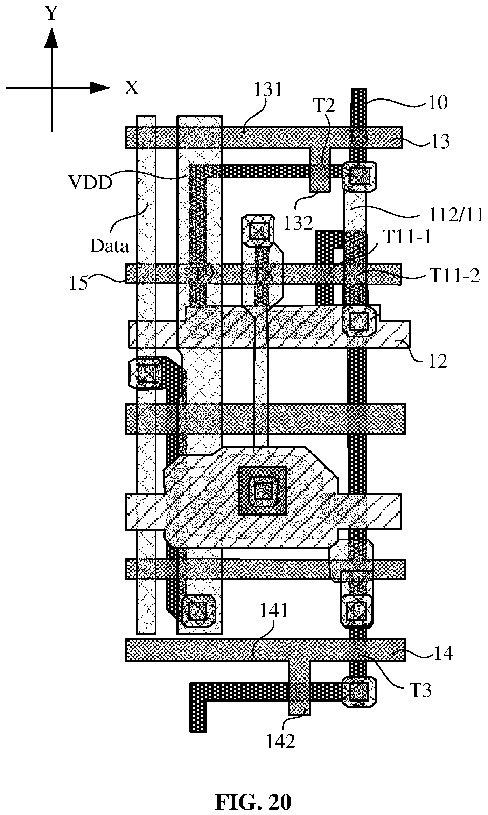

FIG. 20 is a schematic diagram illustrating the structure of another array substrate according to an embodiment of the present application. For example, FIG. 20 shows another layout structure corresponding to the pixel circuit shown in FIG. 17. With reference to FIG. 20, the third metal wire 13 includes a first body portion 131 and a first branch portion 132. The fourth metal wire 14 includes a second body portion 141 and a second branch portion 142. The first body portion 131 and the second body portion 141 extend in the second direction. The first branch portion 132 and the second branch portion 142 extend in the first direction. The active layer 10 forming the second leakage compensation transistor T9 extends upward in the first direction and then extends in the second direction to overlap the first branch portion 132 of the third metal wire 13 to form the first initialization transistor T2. The first body portion 131 of the third metal wire 13 overlaps the active layer 10 to form the second initialization transistor T3 of the pixel circuit in the previous row. The second body portion 141 of the fourth metal wire 14 overlaps the active layer 10 extending in the first direction to form the second initialization transistor T3 of the pixel circuit in the current row. The second branch portion 142 of the fourth metal wire 14 overlaps the active layer 10 extending in the second direction to form the first initialization transistor T2 of the pixel circuit in the next row. Here, the second metal wire 12 is connected to the first initialization transistor T2 and the second initialization transistor T3 via the second sub-metal wire 112, and the first sub-metal wire 111 does not need to be provided so that no vertical line exists for separately transmitting the first initialization voltage Vrefl in the layout structure. Therefore, a larger light transmittance can be obtained.

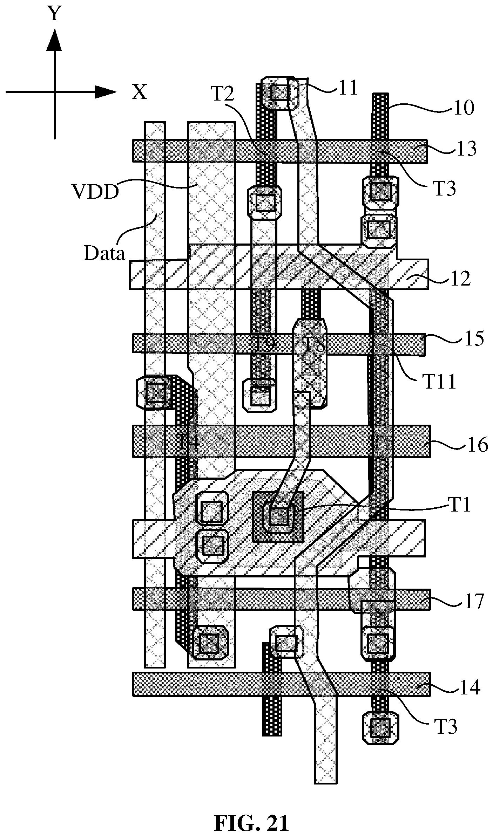

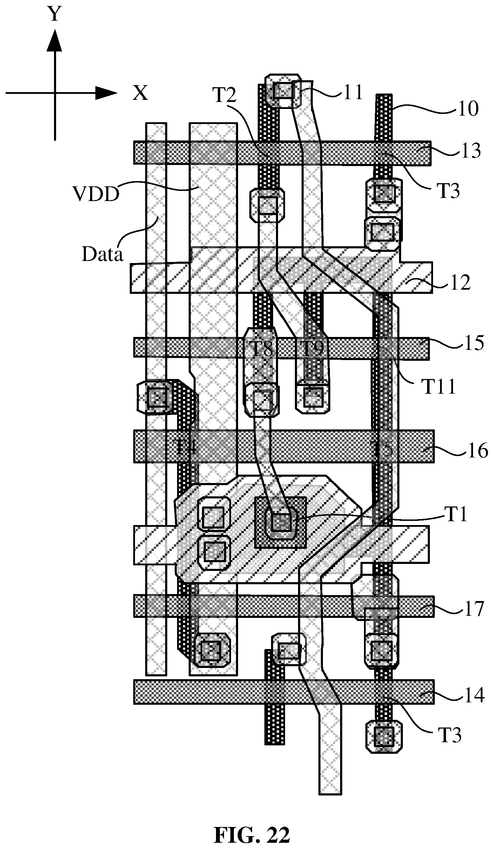

FIG. 21 is a schematic diagram illustrating the structure of another array substrate according to an embodiment of the present application. FIG. 22 is a schematic diagram illustrating the structure of another array substrate according to an embodiment of the present application. FIG. 21 and FIG. 22 separately show another layout structure corresponding to the pixel circuit shown in FIG. 17. Here, the second voltage writing control transistor T11 is a single gate transistor. With reference to FIGS. 21 and 22, the difference is that the first leakage compensation transistor T8 and the second leakage compensation transistor T9 are formed at opposite positions, and the other structures are identical. In this embodiment, the orthographic projection of the fifth metal wire 15 on the substrate is located between the orthographic projection of the sixth metal wire 16 on the substrate and the orthographic projection of the second metal wire 12 on the substrate so that the distance between the first leakage compensation transistor T8 and the gate of the drive transistor T1 can be made shorter, that is, the leakage path of the gate of the drive transistor T1 is shorter, which helps reduce the coupling effect of other signals on the potential of the gate of the drive transistor T1 and can reduce crosstalk between multiple pixel circuits.

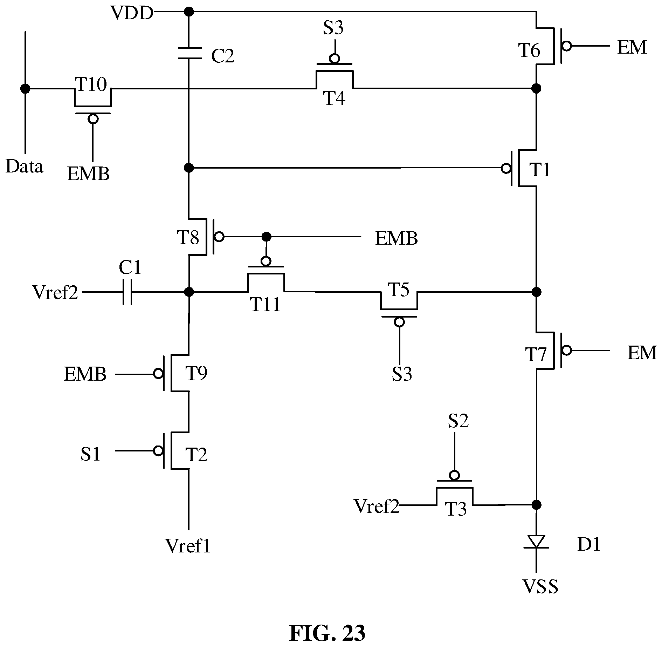

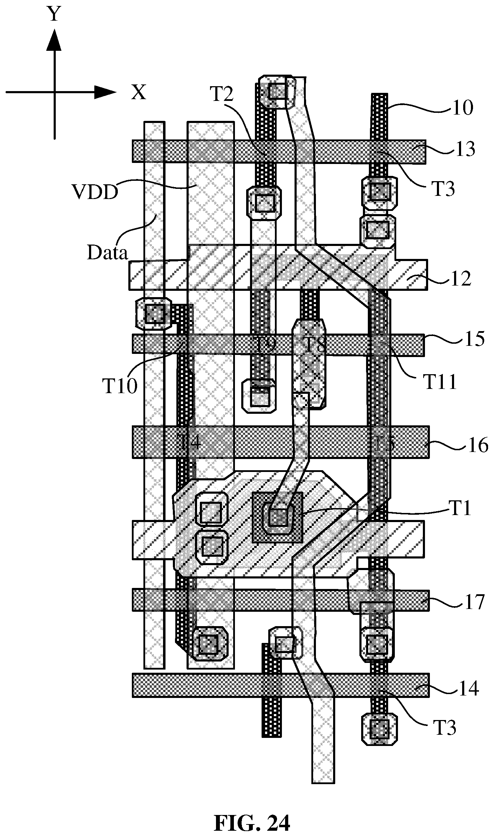

FIG. 23 is a schematic diagram illustrating the structure of another pixel circuit according to an embodiment of the present application. FIG. 24 is a top view illustrating the structure of another array substrate according to an embodiment of the present application. FIG. 24 shows a layout structure corresponding to the pixel circuit shown in FIG. 23. With reference to FIGS. 23 and 24, based on the preceding multiple technical solutions, the pixel circuit of the multiple pixel circuits may include both a first voltage writing control transistor T10 and a second voltage writing control transistor T11; the first voltage writing control transistor T 10, the second voltage writing control transistor T11, the first leakage compensation transistor T8, and the second leakage compensation transistor T9 are all connected to a fifth metal wire (the third scan line EMB). The layout structure shown in FIG. 24 differs from the layout structure shown in FIG. 21 in that in FIG. 24, the active layer 10 forming the data writing transistor T4 extends upwardly in the first direction and overlaps the fifth metal wire 15 to form the first voltage writing control transistor T10. For related descriptions of other structures, reference may be made to the description of FIG. 21, and details are not repeated herein.

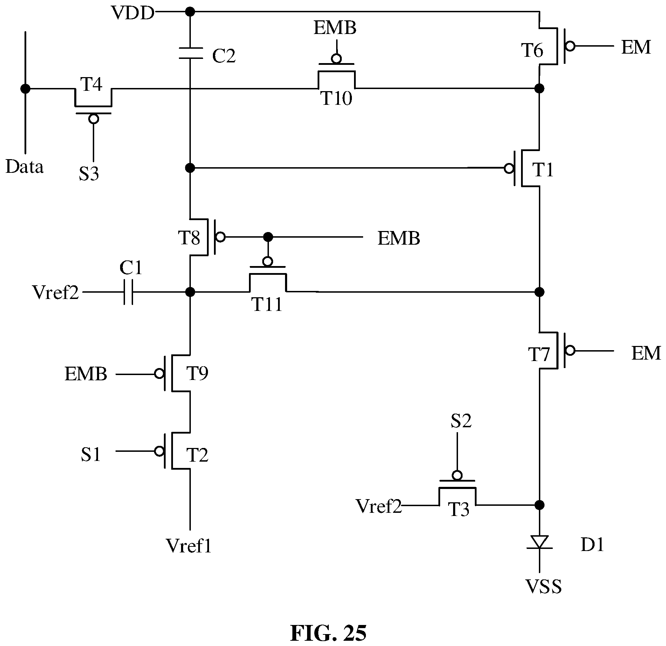

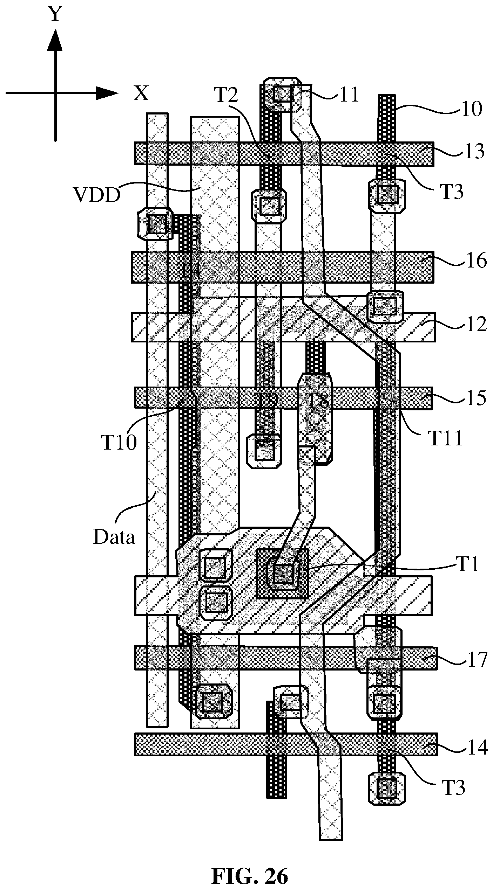

FIG. 25 is a schematic diagram illustrating the structure of another pixel circuit according to an embodiment of the present application. FIG. 26 is a top view illustrating the structure of another array substrate according to an embodiment of the present application. FIG. 26 shows a layout structure corresponding to the pixel circuit shown in FIG. 25. With reference to FIGS. 25 and 26, based on the pixel circuit shown in FIG. 23, the threshold compensation transistor T5 may be removed, and the second voltage writing control transistor T11 is reused as the threshold compensation transistor T5, which helps reduce the number of transistors and the space occupied by the layout.

With continued reference to FIG. 26, in this embodiment, the orthographic projection of the second metal wire 12 on the substrate is located between the orthographic projection of the fifth metal wire 15 on the substrate and the orthographic projection of the sixth metal wire 16 on the substrate, and the orthographic projection of the fifth metal wire 15 on the substrate is located on a side of the orthographic projection of the second metal wire 12 on the substrate adjacent to the orthographic projection of the gate of the drive transistor T1 on the substrate. Thus, the distance between the first leakage compensation transistor T8 formed by the overlap of the fifth metal wire 15 and the active layer 10 and the gate of the drive transistor T1 can be further shortened, which helps reduce the coupling effect of other signals on the potential of the gate of the drive transistor T1 and can reduce crosstalk between multiple pixel circuits.

In the layout structure shown in FIG. 26 in this embodiment, the first metal wire 11 may also be connected to the second metal wire 12 to form a mesh structure; alternatively, the first metal wire 11 may be removed, and the second metal wire 12 may be used for supplying the initialization voltage to the first initialization transistor T2 and the second initialization transistor T3. The specific connection relationship thereof is not described herein again, and reference may be made to the related description in any of the preceding embodiments.

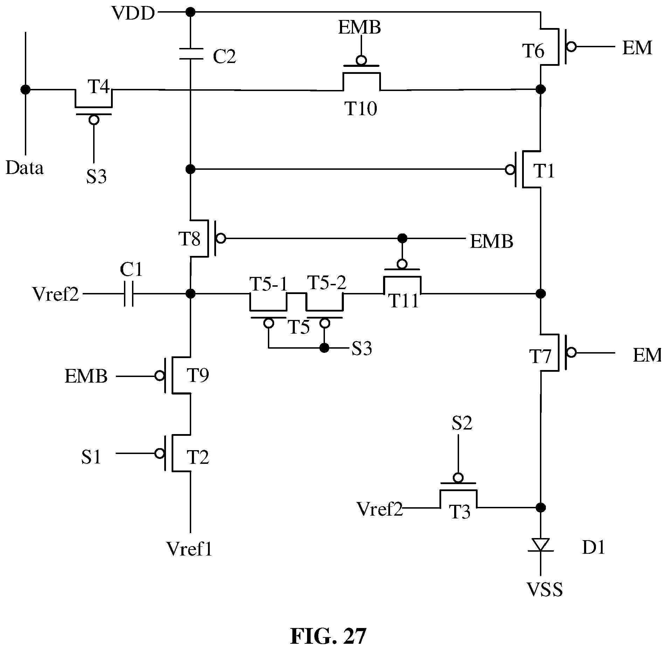

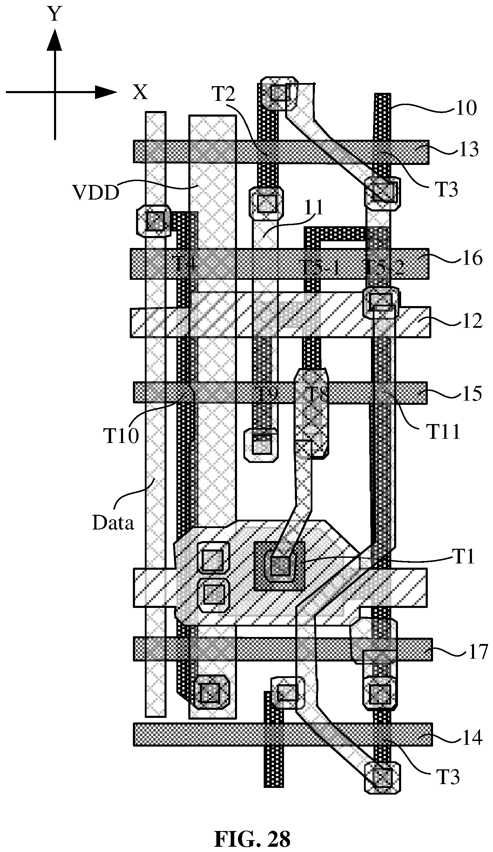

FIG. 27 is a schematic diagram illustrating the structure of another pixel circuit according to an embodiment of the present application. FIG. 28 is a top view illustrating the structure of another array substrate according to an embodiment of the present application. FIG. 28 shows a layout structure corresponding to the pixel circuit shown in FIG. 27. With reference to FIGS. 27 and 28, based on the pixel circuit shown in FIG. 23, the structure of the active layer 10 is changed so that the threshold compensation transistor T5 can be configured as a double-gate transistor to further reduce the leakage current of the gate of the drive transistor T1. For example, the sixth metal wire 16 overlaps the active layer 10 to form a threshold compensation transistor T5 (including a third sub-transistor T5-1 and a fourth sub-transistor T5-2) and a data writing transistor T4, respectively.

FIG. 28 only shows a case in which the first metal wire 11 and the second metal wire 12 are connected together. For a case in which the first metal wire 11 and the second metal wire 12 are insulated from each other, reference may be made to the related description in any embodiment described above, and details are not repeated.

The array substrate provided by this embodiment of the present application, in combination with the structure of the pixel circuit, the drive timing, and the layout, can reduce the gate leakage of the drive transistor, help stabilize the drive current, and thus improve the uniformity of display pictures. Meanwhile, the first metal wire and the second metal wire are configured in layers so that the first metal wire and the second metal wire can transmit different voltages to independently adjust the gate potential of the drive transistor and the anode potential of the light-emitting element. In this manner, the improvement of low-grayscale color cast and low-frequency flickering no longer restrict each other, residual shadows can be improved, and thus the display effect can be greatly enhanced. Moreover, since the first metal wire and the second metal wire are in different layers, the first metal wire and the second metal wire can be arranged in a limited space, thereby improving the utilization rate of the layout space.

For example, an embodiment of the present application also provides a display panel, including the array substrate provided by any embodiment of the present application. Therefore, the display panel also has the beneficial effects described in any of the preceding embodiments.

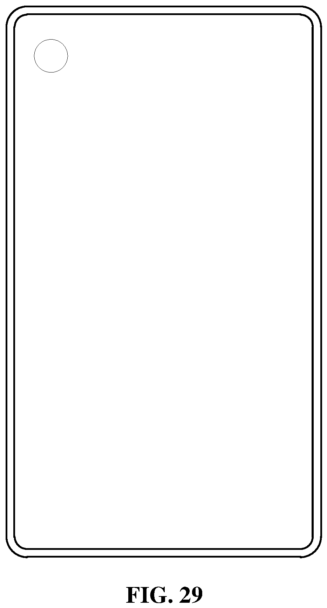

For example, an embodiment of the present application also provides a display device, including the display panel provided by the preceding embodiment. Therefore, the display device also has the beneficial effects described in any of the preceding embodiments. FIG. 29 is a view illustrating the structure of a display device according to an embodiment of the present application. The display device in this embodiment may be a mobile phone or any electronic product with a display function, including but not limited to a television, a laptop, a desktop display, a tablet computer, a digital camera, a smart bracelet, smart glasses, an in-vehicle display, a medical display, industry-controlling equipment, and a touch interactive terminal. This embodiment of the present application is not specifically limited thereto.

Various forms of processes shown above may be adopted with steps reordered, added, or deleted. For example, the steps described in the present application may be performed in parallel, sequentially, or in different orders, as long as the desired results of the technical solutions of the present application can be achieved, and no limitation is imposed herein.

## Claims

1. An array substrate, comprising:
a substrate;
an active layer and a plurality of metal layers, wherein the active layer and the plurality of metal layers are stacked on one side of the substrate; and
a plurality of pixel circuits disposed in the array substrate and a pixel circuit of the plurality of pixel circuits comprising a drive transistor, a first initialization transistor, and a second initialization transistor;
wherein the plurality of metal layers at least comprise a first metal wire extending in a first direction and a second metal wire extending in a second direction, the first metal wire and the second metal wire are located in different layers, and the first initialization transistor is connected between the first metal wire and a gate of the drive transistor and is configured to transmit a first initialization voltage on the first metal wire to the gate of the drive transistor; the second initialization transistor is connected between the second metal wire and a light-emitting element and is configured to transmit a second initialization voltage on the second metal wire to the light-emitting element; and the first direction and the second direction intersect and are perpendicular to thickness direction of the array substrate, respectively.

2. The array substrate of claim 1, wherein the first metal wire comprises a plurality of first sub-metal wires and a plurality of second sub-metal wires, and the plurality of first sub-metal wires and the plurality of second sub-metal wires are arranged in a plurality of columns, wherein each of the plurality of first sub-metal wires is disposed in a column, and part of the plurality of second sub-metal wires are arranged in a column;
the first initialization transistor is connected between corresponding one of the plurality of first sub-metal wires and the gate of the drive transistor; and
the second initialization transistor is connected to corresponding one of the plurality of second sub-metal wires.

3. The array substrate of claim 2, wherein the plurality of second sub-metal wires and the plurality of first sub-metal wires are connected to form a mesh; or the plurality of second sub-metal wires and the plurality of first sub-metal wires are insulated.

4. The array substrate of claim 3, wherein
a first terminal of the first metal wire is connected to the second metal wire, and a second terminal of the first metal wire is connected to the first initialization transistor and the second initialization transistor;
the first initialization transistor and the second initialization transistor are indirectly connected to the second metal wire via the first metal wire; and
the second initialization voltage is reused as the first initialization voltage.

5. The array substrate of claim 1, wherein the plurality of metal layers further comprise a third metal wire and a fourth metal wire, and the third metal wire and the fourth metal wire are a first scan line and a second scan line, respectively; the third metal wire and the fourth metal wire separately extend in the second direction, and an orthographic projection of the second metal wire on the substrate is located between an orthographic projection of the third metal wire on the substrate and an orthographic projection of the fourth metal wire on the substrate; and the third metal wire overlaps the active layer to form the first initialization transistor, and the fourth metal wire overlaps the active layer to form the second initialization transistor; or
the third metal wire comprises a first body portion and a first branch portion, the fourth metal wire comprises a second body portion and a second branch portion, the first body portion and the second body portion extend in the second direction, the first branch portion and the second branch portion extend in the first direction, the first branch portion overlaps the active layer to form the first initialization transistor, and the second body portion overlaps the active layer to form the second initialization transistor.

6. The array substrate of claim 5, wherein the fourth metal wire corresponding to a pixel circuit of the plurality of pixel circuits in an nth row is reused as the third metal wire corresponding to a pixel circuit of the plurality of pixel circuits in an (n + 1)th row, wherein n is an integer greater than or equal to 1.

7. The array substrate of any one of claims 1 to 6, wherein the pixel circuit of the plurality of pixel circuits further comprises a first leakage compensation transistor and a second leakage compensation transistor, a second electrode of the first leakage compensation transistor is connected to the gate of the drive transistor, a first electrode of the first leakage compensation transistor is connected to a second electrode of the second leakage compensation transistor, and a first electrode of the second leakage compensation transistor is connected to the first initialization transistor; and
the plurality of metal layers comprise a first metal layer, a second metal layer, and a third metal layer, wherein the first metal layer comprises the gate of the drive transistor, the second metal layer comprises the second metal wire, and the third metal layer comprises the first metal wire.

8. The array substrate of claim 7, wherein the plurality of metal layers further comprise a fifth metal wire, and the fifth metal wire is a third scan line and is not disposed in a same layer as the first metal wire and the second metal wire; and
an orthographic projection of the fifth metal wire on the substrate is located on one side of the orthographic projection of the second metal wire on the substrate and is staggered with the orthographic projection of the second metal wire, and the fifth metal wire overlaps the active layer to form the first leakage compensation transistor and the second leakage compensation transistor.

9. The array substrate of claim 8, wherein the pixel circuit of the plurality of pixel circuits further comprises a first storage capacitor connected between the second metal wire and the second electrode of the second leakage compensation transistor; and
the second metal wire overlaps the active layer to form the first storage capacitor.

10. The array substrate of any one of claims 1 to 4, wherein the plurality of metal layers further comprise a sixth metal wire extending in the second direction and a seventh metal wire extending in the second direction, and the sixth metal wire and the seventh metal wire are a fourth scan line and a fifth scan line, respectively; and
the sixth metal wire overlaps the active layer to form a data writing transistor and a threshold compensation transistor, and the seventh metal wire overlaps the active layer to form a first light-emitting control transistor and a second light-emitting control transistor.

11. The array substrate of claim 10, wherein the plurality of metal layers further comprise a fifth metal wire extending in the second direction, and the fifth metal wire is a third scan line; and
an orthographic projection of the second metal wire on the substrate is located between an orthographic projection of the fifth metal wire on the substrate and an orthographic projection of the sixth metal wire on the substrate; or, an orthographic projection of the fifth metal wire on the substrate is located between an orthographic projection of the second metal wire on the substrate and an orthographic projection of the sixth metal wire on the substrate.

12. The array substrate of claim 11, wherein the orthographic projection of the fifth metal wire on the substrate is on a side of the orthographic projection of the second metal wire on the substrate adjacent to an orthographic projection of the gate of the drive transistor on the substrate.

13. The array substrate of claim 11, wherein the pixel circuit of the plurality of pixel circuits further comprises a first voltage writing control transistor, and the first voltage writing control transistor and the data writing transistor are connected in series between a data line and a first electrode of the drive transistor; and
the active layer forming the data writing transistor extends in the first direction, overlaps the fifth metal wire, and is connected to the data line through a via, and the fifth metal wire overlaps with the active layer to form the first voltage writing control transistor.

14. The array substrate of claim 13, wherein scan frequency of a scan signal applied on the sixth metal wire, scan frequency of a scan signal applied on a gate of the first initialization transistor, and scan frequency of a scan signal applied on a gate of the second initialization transistor are higher than a preset high scan frequency.

15. The array substrate of claim 8, wherein the pixel circuit of the plurality of pixel circuits further comprises a second voltage writing control transistor connected between a second electrode of the drive transistor and the second electrode of the second leakage compensation transistor; and
the active layer overlapping the second metal wire extends in the first direction and overlaps the fifth metal wire to form the second voltage writing control transistor.

16. The array substrate of claim 1, wherein the first initialization voltage is less than or equal to the second initialization voltage.

17. The array substrate of claim 8, wherein the plurality of metal layers further comprise a sixth metal wire extending in the second direction, the sixth metal wire overlaps the active layer to form a data writing transistor and a threshold compensation transistor, and the pixel circuit further comprises a first voltage writing control transistor and a second voltage writing control transistor;
the first voltage writing control transistor and the data writing transistor are connected in series between a data line and a first electrode of the drive transistor; the active layer forming the data writing transistor extends in the first direction, overlaps the fifth metal wire, and is connected to the data line through a via, and the fifth metal wire overlaps with the active layer to form the first voltage writing control transistor;
the second voltage writing control transistor is connected between a second electrode of the drive transistor and the second electrode of the second leakage compensation transistor, and the active layer overlapping the second metal wire extends in the first direction and overlaps the fifth metal wire to form the second voltage writing control transistor; and
the first voltage writing control transistor, the second voltage writing control transistor, the first leakage compensation transistor, and the second leakage compensation transistor are connected to the fifth metal wire.

18. The array substrate of claim 17, wherein the threshold compensation transistor is double-gate transistor.

19. A display panel, comprising the array substrate of any one of claims 1 to 18.

20. A display device, comprising the display panel of claim 19.
